# EUROPEAN PATENT APPLICATION

(11) **EP 4 498 782 A1**
(43) Date of publication of application: **29.01.2025**
(21) Application number: 23896241.9
(22) Date of filing: 27.09.2023
(51) Int. Cl.: H10K 59/35

(54) **DISPLAY SUBSTRATE AND PREPARATION METHOD THEREFOR, AND DISPLAY APPARATUS**

(30) Priority: 29.11.2022 CN 202211517070
(71) Applicant: Boe Technology Group Co., Ltd., Beijing 100015 (CN)
(72) Inventor: ZHANG, Yongfeng, Beijing 100176 (CN)
(74) Representative: Lavoix
(86) International application number: PCT/CN2023/122094
(87) International publication number: WO 2024/114084

(57) **Abstract**

A display substrate, a manufacture method, and a display device are provided. Display substrate includes a substrate, and a light-emitting device layer on substrate. Light-emitting device layer includes an organic material film layer including an organic material layer and an ion implantation portion; and a material of ion implantation portion includes organic material layer material and doped ions. Light-emitting device layer includes sub-pixels, each sub-pixel includes a first electrode, an organic material layer on the first electrode away from the substrate, and a second electrode on the organic material layer away from the substrate; and organic material layer includes a light-emitting material layer. First electrodes of adjacent two sub-pixels are at an interval. Ion implantation portion is between adjacent two sub-pixels, and ion implantation portion is to electrically isolate film layers of adjacent two sub-pixels that are between first electrodes and a surface of light-emitting material layer away from substrate.

## Description

### TECHNICAL FIELD

The present disclosure relates to display technology, and in particular, to a display substrate and a manufacture method thereof, and a display device.

### BACKGROUND

Organic light-emitting diodes (OLEDs) belong to electroluminescent devices, having features such as self-luminescence, high light-emitting efficiency, low operating voltage, lightweight and thin structure, flexibility and simple manufacturing process, and are widely used in fields such as display and lighting.

### SUMMARY

The present disclosure provides a display substrate and a manufacture method thereof, and a display device.

The first aspect of embodiments of the present disclosure provides a display substrate. The display substrate includes: a substrate; a light-emitting device layer on the substrate, where the light-emitting device layer includes an organic material film layer, the organic material film layer includes an organic material layer and an ion implantation portion, and a material of the ion implantation portion includes a material of the organic material layer and doped ions; the light-emitting device layer includes a plurality of sub-pixels, each sub-pixel includes a first electrode, the organic material layer on the first electrode and away from the substrate, and a second electrode on the organic material layer and away from the substrate; where the organic material layer includes a light-emitting material layer; where first electrodes of adjacent sub-pixels among the plurality of sub-pixels are arranged at an interval; and where the ion implantation portion is between adjacent two sub-pixels among the plurality of sub-pixels, and the ion implantation portion is to electrically isolate film layers of the adjacent two sub-pixels that are between the first electrodes and a surface of the light-emitting material layer away from the substrate.

In an embodiment, the ion implantation portion includes a P-type doped layer and a N-type doped layer.

In an embodiment, one of the first electrode and the second electrode is an anode and the other one of the first electrode and the second electrode is a cathode, and the ion implantation portion includes an N-type doped layer and a P-type doped layer on the N-type doped layer and away from the anode.

In an embodiment, the first electrode is an anode, the second electrode is a cathode, and the organic material layer includes a first organic layer between the first electrode and the light-emitting material layer and a second organic layer between the light-emitting material layer and the second electrode; where the first organic layer includes a hole injection layer, a hole transport layer, an electron blocking layer, or any combination thereof, and the second organic layer includes an electron injection layer, an electron transport layer, a hole blocking layer, or any combination thereof; and where the N-type doped layer penetrates through the first organic layer and the light-emitting material layer; and, a distance between the substrate and a surface of the P-type doped layer away from the substrate is less than or equal to a distance between the substrate and a surface of the second organic layer away from the substrate, or, the display substrate further includes an encapsulation layer on the second electrode and away from the substrate, and the P-type doped layer penetrates film layers between the light-emitting material layer and a surface of the encapsulation layer away from the substrate.

In an embodiment, the display substrate further includes a pixel defining layer on the substrate, and the pixel defining layer is provided with a plurality of pixel openings; where at least two sub-pixels with a same luminescence color are provided in a same pixel opening, and at least part of the organic material layers of the at least two sub-pixels is in the pixel opening; where among the at least two sub-pixels in the same pixel opening, the ion implantation portion is between adjacent two sub-pixels; and the ion implantation portion is to electrically isolate film layers of the adjacent two sub-pixels in the same pixel opening between the first electrodes and a surface of the light-emitting material layer away from the substrate.

In an embodiment, the display substrate further includes an isolation column in the pixel opening, the isolation column is closer to the substrate than the ion implantation portion and between adjacent two first electrodes, and a height of the isolation column is greater than a thickness of the first electrode.

In an embodiment, a material of the isolation column includes an inorganic material.

In an embodiment, the display substrate further includes a driving circuit layer between the light-emitting device layer and the substrate, where the driving circuit layer includes a plurality of pixel circuits, and, at least two sub-pixels of the at least two sub-pixels in the same pixel opening are electrically connected with a same pixel circuit.

In an embodiment, the driving circuit layer further includes a data signal gating circuit and a data signal line, where the pixel circuit includes a data writing transistor, one end of the data signal line is connected with the data writing transistor, the other end of the data signal line is connected with the data signal gating circuit, and the data signal gating circuit is configured to input a data signal of a selected sub-pixel to the data signal line.

In an embodiment, there are a plurality of the sub-pixels in the pixel opening, and the plurality of the sub-pixels in a same pixel opening are electrically connected with a same pixel circuit; the data signal gating circuit includes a plurality of data gating signal lines and a plurality of switch transistors respectively corresponding to the sub-pixels; the switch transistors corresponding to a same pixel opening are connected in parallel, one end of each of the switch transistors is connected with a driving chip, and the other end of each of the switch transistors is connected with a same data signal line; where a gate electrode of the switch transistor corresponding to each sub-pixel is connected with one of the data gating signal lines; and the data gating signal line is configured to turn on the switch transistor corresponding to a selected sub-pixel, such that a data signal provided by the driving chip to the selected sub-pixel is transmitted to the data signal line.

In an embodiment, there are a plurality of the sub-pixels in the pixel opening, and the plurality of the sub-pixels in a same pixel opening are electrically connected with a same pixel circuit; the data signal gating circuit includes a plurality of data gating signal lines and a plurality of switch transistors respectively corresponding to the sub-pixels one by one; among the sub-pixels in the same pixel opening, switch transistors corresponding to at least two sub-pixels are connected in parallel, one end of each of switch transistors connected in parallel is connected with a driving chip, and the other end of each of the switch transistors is connected with one of the data signal lines; among the sub-pixels in the same pixel opening, the switch transistors corresponding to the sub-pixels are connected with at least two data signal lines; at least two switch transistors connected with different data signal lines are connected with a same data gating signal line; and the data gating signal line is configured to turn on switch transistors corresponding to selected sub-pixels connected with the same data gating signal line, such that a data signal provided by the driving chip to the selected sub-pixel is transmitted to the data signal line.

In an embodiment, the first electrode includes a first conductive layer, a second conductive layer on the first conductive layer and away from the substrate, and a third conductive layer on the second conductive layer and away from the substrate, a material of the second conductive layer is selected from silver, aluminum, molybdenum, or any combination thereof, and a material of the first conductive layer is selected from titanium, titanium nitride, transparent metal oxide, or any combination thereof, and a material of the third conductive layer is selected from titanium, titanium nitride, transparent metal oxide, or any combination thereof.

In an embodiment, the display substrate further includes a pixel defining layer on the substrate, and the pixel defining layer is provided with a plurality of pixel openings; at least two sub-pixels with a same luminescence color are provided in a same pixel opening, and at least part of the organic material layers of the at least two sub-pixel is in the pixel opening; and among the at least two sub-pixels in the same pixel opening, a distance between the first electrodes of adjacent two sub-pixels is less than 5.0µm.

In an embodiment, the display substrate further includes a pixel defining layer on the substrate, and the pixel defining layer is provided with a plurality of pixel openings; at least one sub-pixel is provided in a same pixel opening, and at least part of the organic material layer of the at least one sub-pixel is in the pixel opening; and the ion implantation portion is on the pixel defining layer and away from the substrate, and the ion implantation portion is to electrically isolate the sub-pixels in adjacent pixel openings.

In an embodiment, the first electrode is an anode, and the second electrode is a cathode; and the organic material layer includes an electron transport layer between the light-emitting material layer and the second electrode, the electron transport layer includes at least two electron transport film sub-layers, and at least one of the electron transport film sub-layers is on the ion implantation portion and away from the substrate.

In an embodiment, the electron transport layer includes a first electron transport film sub-layer and a second electron transport film sub-layer on the first electron transport film sub-layer and away from the substrate; the ion implantation portion penetrates through the first electron transport film sub-layer; and the second electron transport film sub-layer is on the ion implantation portion and away from the substrate, and is in direct contact with the ion implantation portion.

In an embodiment, the sub-pixels include a first color sub-pixel, a second color sub-pixel, and a third color sub-pixel, and there are a plurality of pixel openings arranged in a plurality of columns; where among adjacent two columns of the pixel openings, the first color sub-pixels and the second color sub-pixels are in one column of the pixel openings, the pixel openings of the first color sub-pixels and the pixel openings of the second color sub-pixels are alternately arranged, and the third color sub-pixels are in the other column of the pixel openings; and where there are at least two first color sub-pixels in a pixel opening of the first color sub-pixels, there are at least two second color sub-pixels in a pixel opening of the second color sub-pixels, there are at least two third color sub-pixels in a pixel opening of the third color sub-pixels, and respective sub-pixels in a same pixel opening are arranged at an interval in a row direction, or respective sub-pixels in a same pixel opening are arranged at an interval in a column direction; or, there are a plurality of the first color sub-pixels in the pixel opening of the first color sub-pixels, there are a plurality of the second color sub-pixels in the pixel opening of the second color sub-pixels, there are a plurality of the third color sub-pixels in the pixel opening of the third color sub-pixels, and a plurality of the sub-pixels in a same pixel opening are arranged in a plurality of rows and columns.

The second aspect of embodiments of the present disclosure provides a method of manufacturing a display substrate, including: providing a substrate; and forming a light-emitting device layer on the substrate; where the light-emitting device layer includes an organic material film layer, the organic material film layer includes an ion implantation portion and an organic material layer; the light-emitting device layer includes a plurality of sub-pixels, each sub-pixel includes a first electrode, the organic material layer on the first electrode and away from the substrate, and a second electrode on the organic material layer and away from the substrate, and the organic material layer includes a light-emitting material layer; and forming the ion implantation portion includes: forming an organic film layer on the first electrode, performing ion implantation on the organic film layer to form the ion implantation portion, a portion of the organic film layer outside the ion implantation portion forms at least part film layer of the organic material layer, and where the ion implantation portion is to electrically isolate film layers of the adjacent two sub-pixels that are between the first electrodes and a surface of the light-emitting material layer away from the substrate.

In an embodiment, performing ion implantation on the organic film layer to form an ion implantation portion includes: injecting P-type ions and/or N-type ions into the organic film layer by an ion implantation process, to form the ion implantation portion.

In an embodiment, the organic film layer includes a first organic layer between the first electrode and the light-emitting material layer, and a third organic layer on the light-emitting material layer and away from the substrate; the first organic layer includes at least one of a hole injection layer, a hole transport layer, or an electron blocking layer; and the third organic layer includes at least one of an electron injection layer, an electron transport layer, or a hole blocking layer; and injecting N-type ions into the first organic layer and the light-emitting material layer by an ion implantation process, to obtain an N-type doped layer penetrating through the first organic layer and the light-emitting material layer, and injecting P-type ions into the third organic layer to obtain a P-type doped layer penetrating through the third organic layer.

In an embodiment, the display substrate further includes a pixel defining layer on the substrate, and the pixel defining layer is provided with a plurality of pixel openings; at least two sub-pixels with a same luminescence color are provided in a same pixel opening, at least part of the organic material layers of the at least two sub-pixels is in the pixel opening, and the ion implantation portion is formed between adjacent two sub-pixels in the same pixel opening; or, the ion implantation portion is formed on the pixel defining layer and away from the substrate.

In an embodiment, when at least two sub-pixels with the same luminescence color are provided in the same pixel opening, the manufacture method further includes: forming an isolation column by a dry etching process, the isolation column is between the adjacent two first electrodes in the same pixel opening, and a height of the isolation column is greater than a thickness of the first electrode; and a material of the isolation column includes an inorganic material.

In an embodiment, performing ion implantation on the organic film layer to form an ion implantation portion is performed before forming the second electrode; before performing ion implantation on the organic film layer to form the ion implantation portion, the manufacture method further includes: forming a mask layer with a hollow portion on the organic film layer; where forming the mask layer with the hollow portion on the organic film layer includes: sequentially forming a protective layer and a barrier layer on the organic film layer, where a material of the protective layer includes a fluorinated polymer material; simultaneously performing exposure processing on the protective layer and the barrier layer; sequentially performing development processing on the barrier layer and the protective layer, to obtain a patterned protective layer and a patterned barrier layer, where an orthographic projection of the patterned barrier layer onto the substrate is within an orthographic projection of the patterned protective layer onto the substrate, to obtain the mask layer including the patterned protective layer and the patterned barrier layer; performing ion implantation on the organic film layer to form the ion implantation portion includes: performing ion implantation on the organic film layer through the hollow portion of the mask layer; where the organic material layer includes an electron transport layer including at least two electron transport film sub-layers; after performing ion implantation on the organic film layer to form the ion implantation portion, the manufacture method further includes: removing the mask layer; and forming at least one electron transport film sub-layer on the organic film layer and away from the substrate; or, the display substrate further includes an encapsulation layer on the light-emitting device layer and away from the substrate, the encapsulation layer only includes an inorganic layer, and a step of performing ion implantation on the organic film layer to form the ion implantation portion is performed after a step of forming the second electrode.

In an embodiment, forming the first electrode includes: sequentially forming a first conductive film layer, a second conductive film layer on the first conductive film layer and away from the substrate, and a third conductive film layer on the second conductive film layer and away from the substrate, where a material of the second conductive film layer is selected from at least one of aluminum or molybdenum, and materials of the first conductive film layer and the third conductive film layer are respectively selected from at least one of titanium, titanium nitride, or transparent metal oxide, and orthographic projections of the first electrode film layer, the second conductive film layer, and the third conductive film layer onto the substrate cover the pixel defining layer and the pixel openings; etching the first conductive film layer, the second conductive film layer, and the third conductive film layer by a dry etching process or a wet etching process, to obtain the first electrode; or, sequentially forming the first conductive film layer, the second conductive film layer on the first conductive film layer and away from the substrate, and the third conductive film layer on the second conductive film layer and away from the substrate, where a material of the second conductive film layer includes silver, and materials of the first conductive film layer and the third conductive film layer are respectively selected from at least one of titanium, titanium nitride, or transparent metal oxide, and orthographic projections of the first electrode film layer, the second conductive film layer, and the third conductive film layer onto the substrate cover the pixel defining layer and the pixel openings; etching the first conductive film layer, the second conductive film layer, and the third conductive film layer by a wet etching process, to obtain the first electrode.

The third aspect of embodiments of the present disclosure provides a display device, the display device includes the display substrate described above.

In a display substrate and a manufacture method thereof, and a display device provided by embodiments of the present disclosure, the organic material film layer of the light-emitting device layer includes an organic material layer of each sub-pixel and an ion implantation portion between adjacent sub-pixels, and the ion implantation portion can electrically isolate film layers of the adjacent sub-pixels that are between the first electrodes and a surface of the light-emitting material layer away from the substrate, which can thereby reduce electrical crosstalk between the adjacent sub-pixels and improving the display effect of the display substrate.

### BRIEF DESCRIPTION OF DRAWINGS

FIG. 1 is a partial cross-sectional view of a display substrate according to an exemplary embodiment of the present disclosure;
FIG. 2 is a partial cross-sectional view of a display substrate according to another exemplary embodiment of the present disclosure;
FIG. 3 is a partial cross-sectional view of a display substrate according to another exemplary embodiment of the present disclosure;
FIG. 4 is a partial cross-sectional view of a display substrate according to another exemplary embodiment of the present disclosure;
FIG. 5 is a schematic arrangement diagram of sub-pixels of a display substrate according to an exemplary embodiment of the present disclosure;
FIG. 6 is a schematic arrangement diagram of sub-pixels of a display substrate according to another exemplary embodiment of the present disclosure;
FIG. 7 is a schematic arrangement diagram of sub-pixels of a display substrate according to another exemplary embodiment of the present disclosure;
FIG. 8 is a schematic circuit diagram of a pixel circuit according to an exemplary embodiment of the present disclosure;
FIG. 9 is a schematic circuit diagram of a data signal gating circuit according to an exemplary embodiment of the present disclosure;
FIG. 10 is a schematic circuit diagram of a data signal gating circuit according to another exemplary embodiment of the present disclosure;
FIG. 11 is a flow diagram of a method of manufacturing a display substrate according to an exemplary embodiment of the present disclosure;
FIG. 12 is a flow diagram of a method of manufacturing a display substrate according to another exemplary embodiment of the present disclosure;
FIG. 13 is a partial cross-sectional view of a first intermediate structure of a display substrate according to an exemplary embodiment of the present disclosure;
FIG. 14 is a top view of the first intermediate structure illustrated in FIG. 13;
FIG. 15 is a partial cross-sectional view of a second intermediate structure of a display substrate according to an exemplary embodiment of the present disclosure;
FIG. 16 is a partial cross-sectional view of a third intermediate structure of a display substrate according to an exemplary embodiment of the present disclosure;
FIG. 17 is a partial cross-sectional view of a fourth intermediate structure of a display substrate according to an exemplary embodiment of the present disclosure;
FIG. 18 is a top view of the fourth intermediate structure illustrated in FIG. 17;
FIG. 19 is a partial cross-sectional view of a fifth intermediate structure of a display substrate according to an exemplary embodiment of the present disclosure.

### DETAILED DESCRIPTION

Embodiments will be described in detail here, examples of which are illustrated in the accompanying drawings. When the following description relates to the accompanying drawings, unless specified otherwise, the same numerals in different drawings represent the same or similar elements. The implementations described in the following exemplary embodiments do not represent all implementations consistent with the present disclosure. Conversely, they are merely examples of apparatuses and methods consistent with some aspects of the present disclosure as detailed in the appended claims.

The terms used in this disclosure are merely for the purpose of describing specific embodiments, and are not intended to limit this disclosure. The terms "a," "said" and "the" of singular forms used in this application and the appended claims are also intended to include plural forms, unless the context clearly indicates otherwise. It should also be understood that, the term "and/or" used herein indicates and includes any or all possible combinations of one or more associated listed items.

It should be understood that although the terms such as first, second, and third may be used herein to describe various information, such information should not be limited to these terms. These terms are only used to distinguish information of the same category with each other. For example, without departing from the scope of the present disclosure, first information may be referred as second information; and similarly, second information may also be referred as first information. Depending on the context, the word "if' as used herein may be interpreted as "when" or "upon" or "in response to determining".

Embodiments of the present disclosure provides a display substrate and a manufacture method thereof, and a display device. A display substrate and a manufacture method thereof, and a display device in embodiments of present disclosure are described in detail below with reference to the accompanying drawings. If there is no conflict, features in the embodiments described below may complement each other or be combined with each other.

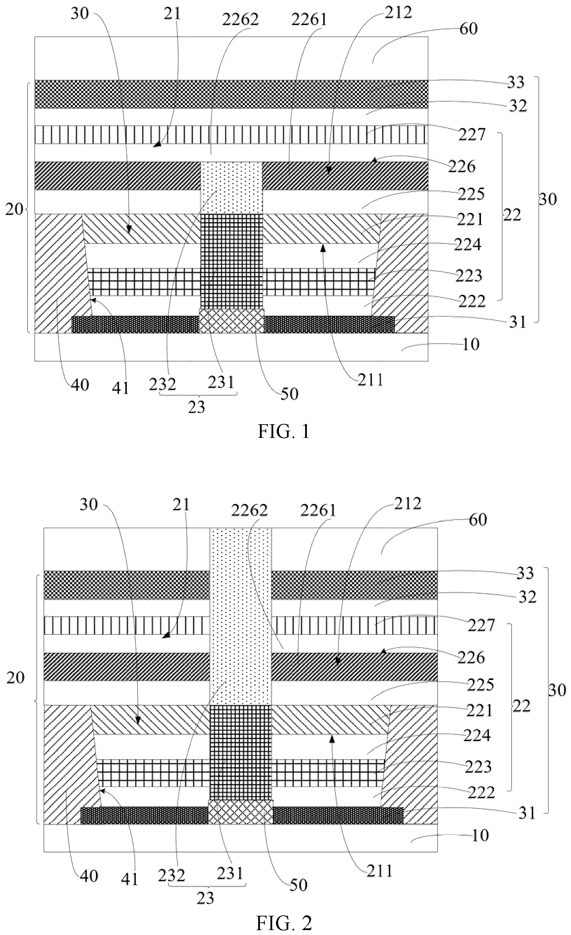

Embodiments of the present disclosure provides a display substrate. As illustrated in FIG. 1 to FIG. 3, the display substrate includes a substrate 10, and a light-emitting device layer 20 on the substrate 10.

The light-emitting device layer 20 includes an organic material film layer 21, the organic material film layer 21 includes an organic material layer 22 and an ion implantation portion 23, and a material of the ion implantation portion 23 includes a material of the organic material layer and doped ions. The light-emitting device layer 20 includes a plurality of sub-pixels 30, each sub-pixel 30 includes a first electrode 31, the organic material layer 22 on the first electrode 31 and away from the substrate 10, and a second electrode 32 on the organic material layer 22 and away from the substrate 10. The organic material layer 22 includes a light-emitting material layer 221. The first electrodes 31 of adjacent sub-pixels 30 are arranged at an interval. The ion implantation portion 23 is between adjacent two sub-pixels 30, and the ion implantation portion 23 is to electrically isolate film layers of the adjacent two sub-pixels 30 that are between the first electrodes 31 and a surface of the light-emitting material layer 221 away from the substrate 10.

In a display substrate provided by embodiments of the present disclosure, the organic material film layer of the light-emitting device layer 20 includes an organic material layer 22 of each sub-pixel 30 and an ion implantation portion 23 between adjacent sub-pixels 30, and the ion implantation portion 23 can electrically isolate film layers of the adjacent sub-pixels 30 that are between the first electrodes 31 and a surface of the light-emitting material layer 221 away from the substrate 10 , which can thereby reduce electrical crosstalk between the adjacent sub-pixels 30 and improving the display effect of the display substrate. The ion implantation portion 23 may be obtained by ion implantation technology to inject ions into organic materials, without need for providing an additional structure between adjacent two sub-pixels, and the process is simple and easy to implement.

In an embodiment, the substrate 10 may be a flexible substrate or a rigid substrate. The material of the flexible substrate layer may include one or more of polyimide, polyethylene terephthalate, or polycarbonate. The material of the rigid substrate can be glass, silicon, etc.

In an embodiment, as illustrated in FIG. 1 to FIG. 3, the light-emitting device layer 20 further includes a pixel defining layer 40, the pixel defining layer 40 is provided with a plurality of pixel openings 41, and the plurality of pixel openings 41 are arranged at an interval. At least one sub-pixel 30 is in one pixel opening 41, and at least part of the organic material layer 22 of the sub-pixel 30 is in the corresponding pixel opening 41. The first electrode 31 is on a side of the pixel defining layer 40 towards the substrate 10, and the pixel opening 41 exposes a part of the first electrode 31 of the corresponding sub-pixel 30.

In an embodiment, as illustrated in FIG. 1 and FIG. 2, the light-emitting device layer 20 further includes a light extraction layer 33 on the second electrode 32 and away from the substrate.

In an embodiment, as illustrated in FIG. 1 and FIG. 2, the display substrate further includes an encapsulation layer 60 on the light-emitting device layer 20 and away from the substrate. The encapsulation layer 60 may be a thin film encapsulation layer, which may include, for example, two inorganic layers and an organic layer between the two inorganic layers. Alternatively, the encapsulation layer 60 may include only one inorganic layer.

In an embodiment, the display substrate further includes a driving circuit layer between the light-emitting device layer 20 and the substrate 10, and the driving circuit layer includes a plurality of pixel circuits. Pixel circuits are used to drive sub-pixels.

In an embodiment, one of the first electrode 31 and the second electrode 32 is an anode, and the other is a cathode. The second electrode of each sub-pixel in the display substrate may be connected together into a common electrode.

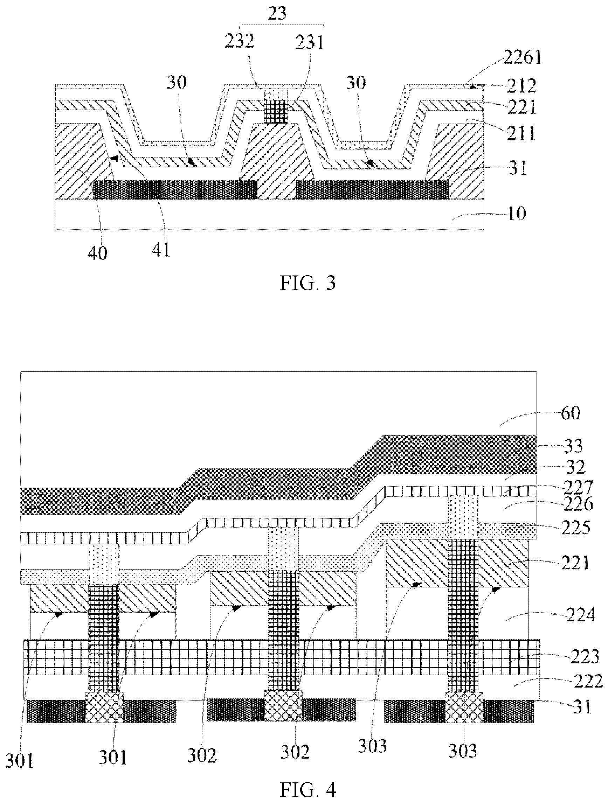

In an embodiment, as illustrated in FIG. 1 to FIG. 3, the organic material film layer 21 includes a first organic layer 211 between the first electrode 31 and the light-emitting material layer 221, and a second organic layer 212 between the light-emitting material layer 221 and the second electrode. When the first electrode 31 is an anode and the second electrode 32 is a cathode, the first organic layer 211 may include at least one of a hole injection layer, a hole transport layer, or an electron blocking layer, and the second organic layer 212 may include at least one of a hole blocking layer, an electron transport layer, or an electron injection layer. As illustrated in FIG. 1 and FIG. 3, the first electrode 31 is an anode, the second electrode 32 is a cathode, the first organic layer 211 includes a hole injection layer 222, a hole transport layer 223, and an electron blocking layer 224, the second organic layer 212 includes a hole blocking layer 225, an electron transport layer 226, and an electron injection layer 227.

In an embodiment, the ion implantation portion 23 includes a P-type doped layer 232 and/or an N-type doped layer 231. Tests prove that, arranging the organic material film layer 21 to include a P-type doped layer 232, or an N-type doped layer 231, or both a P-type doped layer 232 and an N-type doped layer 231 can electrically isolate, for the two sub-pixels 30 on both sides of the ion implantation portion 23, the light-emitting material layer 221 and the film layers between the light-emitting material layer 221 and the first electrode 31, thereby reducing electrical crosstalk between the adjacent sub-pixels 30. The P-type doped layer 232 may be obtained by injecting P-type ions into the organic material through an ion implantation process, and the N-type doped layer 231 may be obtained by injecting N-type ions into the organic material layer through an ion implantation process. P-type ions may include, for example, at least one of hydrogen ions, or boron ions, etc, and N-type ions may include, for example, at least one of fluoride ions, oxygen ions, chloride ions, or sulfur ions, etc.

In an embodiment, the ion implantation portion 23 includes an N-type doped layer and a P-type doped layer on the N-type doped layer and away from the anode. A film layer between the anode and the light-emitting material layer 221 is configured to transport holes, and a film layer between the light-emitting material layer 221 and the cathode is configured to transport electrons. Arranging the portion of the ion implantation portion 23 near the anode to be an N-type doped layer can more effectively prevent, for adjacent sub-pixels 30, the hole transport in film layers between the anode and the light-emitting material layer 221, thereby effectively reducing electrical crosstalk between adjacent sub-pixels 30; and arranging the portion of the ion implantation portion 23 near the cathode to be a P-type doped layer can more effectively prevent, for adjacent sub-pixels 30, the electron transport in film layers between the cathode and the light-emitting material layer 221, thereby effectively reducing electrical crosstalk between adjacent sub-pixels 30. In an embodiment illustrated in FIG. 1 to FIG. 3, the first electrode 31 is an anode, the second electrode 32 is a cathode, and the ion implantation portion 23 includes an N-type doped layer 231 and a P-type doped layer 232 on the N-type doped layer 231 and away from the substrate 10.

Further, as illustrated in FIG. 1 and FIG. 2, the first electrode 31 is an anode, the second electrode 32 is a cathode, the N-type doped layer 231 penetrates through the first organic layer 211 and the light-emitting material layer 221, and a distance between the surface of the P-type doped layer 232 away from the substrate 10 and the substrate 10 is less than or equal to a distance between the surface of the second organic layer 212 away from the substrate 10 and the substrate10. By arranging the N-type doped layer 231 to penetrate through the first organic layer 211 and the light-emitting material layer 221, the N-type doped layer can effectively prevent hole transport between the first organic layer 211 and the light-emitting material layer 221 of adjacent sub-pixels 30, thereby effectively improving the electrical crosstalk situation between adjacent sub-pixels 30; and by arranging the distance between the substrate 10 and the surface of the P-type doped layer 232 away from the substrate 10 to be less than or equal to the distance between the substrate10 and the surface of the second organic layer 212 away from the substrate 10, that is, the P-type doped layer 232 penetrates at least part of the second organic layer 212, and the P-type doped layer 232 prevents electron transport between adjacent sub-pixels 30, which further improves the electrical crosstalk situation between adjacent sub-pixels 30. In an embodiment illustrated in FIG. 1, the P-type doped layer 232 penetrates through the thicknesses of the hole blocking layer 225 and the electron transport layer 226. In other embodiments, the P-type doped layer 232 may penetrate through the second organic layer 212.

In an embodiment, as illustrated in FIG. 2, the P-type doped layer 232 penetrates through the film layers between the surface of the encapsulation layer 60 away from the substrate 10 and the light-emitting material layer 221. Specifically, the P-type doped layer 232 penetrates through the encapsulation layer 60, the light extraction layer 33, the second electrode 32, and the second organic layer 212. In this embodiment, the encapsulation layer 60 may include only one inorganic layer to reduce the energy and concentration of ion implantation during the formation of the ion implantation portion.

In an embodiment, as illustrated in FIG. 1 and FIG. 3, the first electrode 31 is an anode, and the second electrode 32 is a cathode; and the organic material layer includes an electron transport layer 226 between the light-emitting material layer 221 and the second electrode 32, the electron transport layer 226 includes at least two electron transport film sub-layers, and at least one of the electron transport film sub-layers is on the ion implantation portion 23 and away from the substrate 10. Before forming the ion implantation portion 23 by an ion implantation process, a mask layer needs to be formed above the film layer farthest from the substrate 10, the material of the mask layer may be, for example, photoresist, and after forming the ion implantation portion 23, the mask layer needs to be removed. If ion implantation is performed after forming the electron transport layer, during the process of removing the mask layer, a cleaning agent is to be used, which affects the performance of the electron transport layer. By arranging the electron transport layer 226 to include at least two electron transport film sub-layers, and at least one of the electron transport film sub-layers to be located on the ion implantation portion 23 and away from the substrate 10, that is, at least one electron transport film sub-layer to be formed after the ion implantation portion 23 is formed, the electron transport film sub-layer is not to be affected by the mask layer removal process, which can ensure that the light-emitting performance of the light-emitting device is not affected.

In an embodiment, as illustrated in FIG. 1 and FIG. 3, the electron transport layer 226 includes a first electron transport film sub-layer 2261 and a second electron transport film sub-layer 2262 on the first electron transport film sub-layer 2261 and away from the substrate 10. The ion implantation portion 23 penetrates through the first electron transport film sub-layer 2261; and the second electron transport film sub-layer 2262 is on the ion implantation portion 23 and away from the substrate 10, and is in direct contact with the ion implantation portion 23. In this way, the electron transport layer 226 includes two electron transport film sub-layers, which may ensure the light-emitting performance of the light-emitting device without causing a significant increase in the thickness of the display substrate. In an embodiment, the first electrode 31 includes a first conductive layer, a second conductive layer on the first conductive layer and away from the substrate, and a third conductive layer on the second conductive layer and away from the substrate 10, the material of the second conductive layer is selected from at least one of silver, aluminum, or molybdenum, and the materials of the first conductive layer and the third conductive layer are respectively selected from at least one of titanium, titanium nitride, or transparent metal oxide. In this way, the structure of sub-pixel 30 may form a strong microresonant cavity structure, which helps to improve the light-emitting efficiency and color purity of the sub-pixel. At the same time, when the material of the second conductive layer does not include silver, the first electrode 31 of sub-pixel 30 may be etched by a dry etching process during a manufacture process, which has high etching accuracy and helps to reduce the distance between adjacent two first electrodes 31, which helps to increase the light-emitting area of the display substrate; and when the material of the second conductive layer includes silver, the etching may be performed by a wet etching process. In an exemplary embodiment, the material of the first conductive layer is titanium, the material of the second conductive layer is aluminum, and the material of the third conductive layer is indium tin oxide. In some embodiments, the thickness of the first conductive layer is, for example, about 5 nm, the thickness of the second conductive layer is, for example, about 150 nm, and the thickness of the third conductive layer is, for example, about 10 nm. In an embodiment, the display substrate includes sub-pixels 30 with at least three different luminescence colors. For example, as illustrated in FIG. 4, the display substrate may include different types of sub-pixels 30 with three different luminescence colors: sub-pixels 301 with red luminescence color (hereinafter referred to as red sub-pixels), sub-pixels 302 with green luminescence color (hereinafter referred to as green sub-pixels), and sub-pixels 303 with blue luminescence color (hereinafter referred to as blue sub-pixels). An ion implantation portion 23 is provided between adjacent two sub-pixels 30 with the same luminescence color. Specifically, there is an ion implantation portion 23 between adjacent two red sub-pixels 301, an ion implantation portion 23 between adjacent two green sub-pixels 302, and an ion implantation portion 23 between adjacent two blue sub-pixels 303. In an embodiment illustrated in FIG. 4, adjacent sub-pixels 301 with the same luminescence color correspond to a same pixel opening 41.

In an embodiment, as illustrated in FIG. 1 and FIG. 3, at least two sub-pixels 30 with the same luminescence color are provided in a same pixel opening 41, at least part of the organic material layer of the sub-pixel 30 is in the corresponding pixel opening 41, and among the sub-pixels 30 in the same pixel opening 41, the ion implantation portion 23 is provided between adjacent two sub-pixels 30. The ion implantation portion 23 is to electrically isolate film layers of the adjacent two sub-pixels 30 in the same pixel opening 41, where the film layers are between the surface of the light-emitting material layer 221 away from the substrate 10 and the first electrode 31. Without changing the design accuracy of the mask used for evaporating the light-emitting material layer, by arranging the ion implantation portion 23 to electrically isolate adjacent two sub-pixels 30 with the same luminescence color in the same pixel opening 41, the resolution of the display substrate may be improved, and the ion implantation portion 23 between adjacent sub-pixels 30 may avoid electrical crosstalk between adjacent sub-pixels 30.

In an embodiment, when at least two sub-pixels 30 with the same luminescence color are provided in the same pixel opening 41, the sub-pixels include a first color sub-pixel, a second color sub-pixel, and a third color sub-pixel, and a plurality of pixel openings are arranged in a plurality of columns. Among adjacent two columns of the pixel openings, the first color sub-pixels and the second color sub-pixels are in one column of the pixel openings, the pixel openings of the first color sub-pixels and the pixel openings of the second color sub-pixels are alternately arranged, and the third color sub-pixels are in the other column of the pixel openings.

There are at least two first color sub-pixels in a pixel opening of the first color sub-pixels, there are at least two second color sub-pixels in a pixel opening of the second color sub-pixels, there are at least two third color sub-pixels in a pixel opening of the third color sub-pixels, and respective sub-pixels in a same pixel opening are arranged at an interval in a row direction, or sub-pixels in a same pixel opening are arranged at an interval in a column direction. Alternatively, there are a plurality of the first color sub-pixels in the pixel opening of the first color, there are a plurality of the second color sub-pixels are arranged in the pixel opening of the second color, there are a plurality of the third color sub-pixels are arranged in the pixel opening of the third color, and a plurality of the sub-pixels in a same pixel opening are arranged in a plurality of rows and columns.

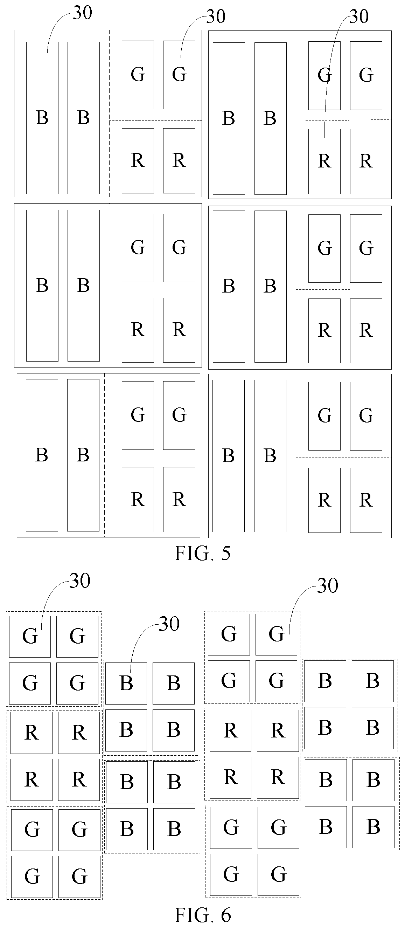

In an embodiment as illustrated in FIG. 5 to FIG. 7, respective sub-pixels 30 in a same dashed box corresponds to one pixel opening (that is, are in one pixel opening), the first color sub-pixel is a red sub-pixel R, the second color sub-pixel is a green sub-pixel G, and the third color sub-pixel is a blue sub-pixel B. Among adjacent two columns of the pixel openings, red sub-pixels R and green sub-pixels G are in one column of the pixel openings, the pixel openings of red sub-pixels R and the pixel openings of green sub-pixels G are alternately arranged, and blue sub-pixels B are in the other column of the pixel openings.

In an embodiment illustrated in FIG. 5, each pixel opening has two sub-pixels. Specifically, two red sub-pixels R are provided in one pixel opening, two green sub-pixels G are provided in one pixel opening, and two blue sub-pixels B are provided in one pixel opening. Respective sub-pixels corresponding to a same pixel opening are arranged at an interval in a row direction. And in an embodiment illustrated in FIG. 5, the sum of the size of the green sub-pixel G in the column direction and the size of the red sub-pixel R in the column direction is essentially the same as the size of the blue sub-pixel B in the column direction, and the central axis of the blue sub-pixel B in the row direction is between the red sub-pixel R and the green sub-pixel G.

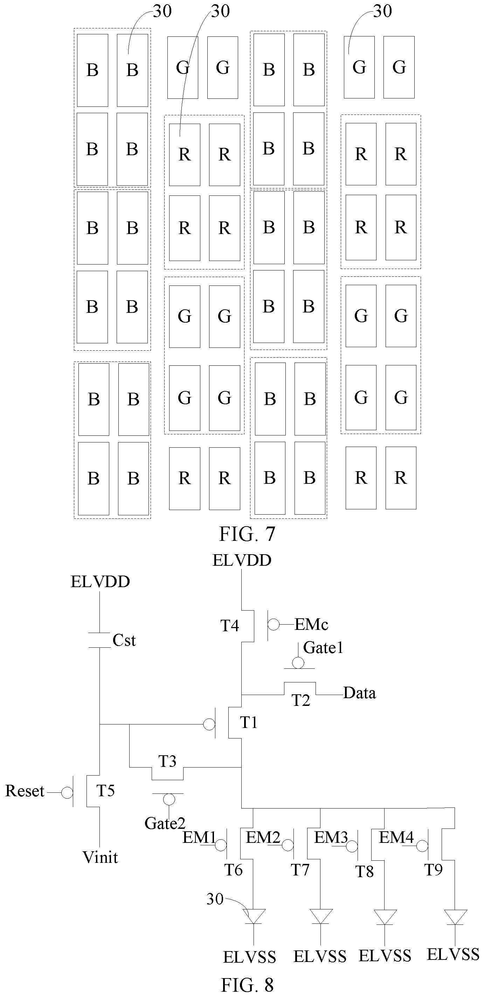

In an embodiment illustrated in FIG. 6 and FIG. 7, four red sub-pixels R are provided in one pixel opening. Specifically, four red sub-pixels R are provided in one pixel opening, four green sub-pixels G are provided in one pixel opening, four blue sub-pixels B are provided in one pixel opening, and the four sub-pixels in the same pixel opening are arranged in two rows and two columns. In an embodiment illustrated in FIG. 6, the size of the blue sub-pixel B in the column direction, the size of the red sub-pixel R in the column direction, and the size of the green sub-pixel G in the column direction are essentially the same, and the central axis of the blue sub-pixel B in the row direction is between the red sub-pixel R and the green sub-pixel G. In an embodiment illustrated in FIG. 7, the sum of the size of the green sub-pixel G in the column direction and the size of the red sub-pixel R in the column direction is essentially the same as the size of the blue sub-pixel B in the column direction, and the central axis of the blue sub-pixel B in the row direction is between the red sub-pixel R and the green sub-pixel G.

In an embodiment, as illustrated in FIG. 1 and FIG. 3, the display substrate further includes an isolation column 50 in the pixel opening 41, the isolation column 50 is between adjacent two first electrodes 31, and the height of the isolation column 50 is greater than the thickness of the first electrode 31. The arrangement of the isolation column 50 may create a step between the organic material layers of adjacent sub-pixels 30, which is more beneficial to break the organic material layer 22 at the top of the isolation column 50, thereby further avoiding electrical crosstalk between adjacent sub-pixels 30.

In an embodiment, the material of the isolation column 50 includes an inorganic material. When using an inorganic material to form an isolation column 50, dry etching technology may be used for etching, which has high etching accuracy and helps to reduce the width of isolation column 50 and minimize the impact of the isolation column 50 on the light-emitting area of sub-pixel 30. In some embodiments, the material of the isolation column 50 includes at least one of silicon oxide or silicon nitride.

In an embodiment, the height of the isolation column 50 ranges from 5nm to 8nm. This arrangement may not only avoid that, since the height of the isolation column 50 is too small, the effect of the organic material layer 22 breaking at the top of the isolation column is relatively small, but also may avoid that, since the height of the isolation column 50 is too large, the etching time is relatively long during the process of forming the isolation column 50, and then the manufacture process time of the display substrate is increased. In some embodiments, the height of the isolation column 50 is, for example, 5nm, 6nm, 7nm, 8nm, etc.

In an embodiment, when at least two sub-pixels 30 with the same luminescence color are provided in the same pixel opening 41, the first electrode 31 includes the first conductive layer, the second conductive layer on the first conductive layer and away from the substrate, and the third conductive layer on the second conductive layer and away from the substrate 10, the material of the second conductive layer is selected from at least one of silver, aluminum, or molybdenum, the materials of the first conductive layer and the third conductive layer are respectively selected from at least one of titanium, titanium nitride, or transparent metal oxide, and among the sub-pixels 30 in the same pixel opening 41, a distance between the first electrodes 31 of adjacent two sub-pixels 30 is less than 5.0µm. When the material of the second conductive layer does not include silver, the first electrode may be formed by a dry etching process, such that a distance between first electrodes 31 of adjacent two sub-pixels 30 in the same pixel opening is small and the light-emitting area of the sub-pixels 30 is increased. When the material of the second conductive layer includes silver, the first electrode may be formed by a wet etching process. In particular, when the first electrode is formed by a dry etching process, the distance between the first electrodes 31 of adjacent two sub-pixels may be less than or equal to 2.0µm. In an embodiment, among the sub-pixels 30 in the same pixel opening 41, at least two sub-pixels 30 are electrically connected with a same pixel circuit. This arrangement may save the space occupied by pixel circuits. When the size of the display substrate is constant, under the premise that the number of pixel circuits remains unchanged, more sub-pixels 30 can be provided, thereby improving the resolution of the display substrate. In some embodiments, respective sub-pixels in the same pixel opening may share one pixel circuit.

In an embodiment, as illustrated in FIG. 8, the pixel circuit includes a driving transistor T1, data writing transistors T2 and T3, a first light-emitting control transistor T4, a reset transistor T5, second light-emitting control transistors T6, T7, T8, and T9, and a capacitor Cst.

A first pole of the data writing transistor T2 is electrically connected with a first pole of the driving transistor T1, a second pole of the data writing transistor T2 is configured to be electrically connected with the data signal terminal *Data* to receive a data signal, a gate electrode of the data writing transistor T2 is configured to be electrically connected with the scanning signal terminal *Gate1* to receive a scanning signal, a first pole of capacitor Cst is electrically connected with the first power supply terminal ELVDD, and a second pole of capacitor Cst is electrically connected with a gate electrode of driving transistor T1. A first pole of the data writing transistor T3 is electrically connected with a second pole of the driving transistor T1, a second pole of the data writing transistor T3 is electrically connected with a gate electrode of the driving transistor T1, and a gate electrode of the data writing transistor T3 is configured to be electrically connected with the scanning signal terminal *Gate2* to perform compensation while writing the data signal. A first pole of the reset transistor T5 is configured to be electrically connected with the reset power supply terminal *Vinit1* to receive a reset signal, a second pole of the reset transistor T5 is electrically connected with the gate electrode of the driving transistor T1, and a gate electrode of the reset transistor T5 is configured to be electrically connected with the reset control signal terminal *Reset* to receive a reset control signal. A first pole of the first light-emitting control transistor T4 is electrically connected with the first power supply terminal ELVDD, a second pole of the first light-emitting control transistor T4 is electrically connected with the first pole of the driving transistor T1, and a gate electrode of the first light-emitting control transistor T4 is configured to be electrically connected with the first light-emitting control signal line EMc to receive a first light-emitting control signal. First poles of the second light-emitting control transistors T6, T7, T8, and T9 are electrically connected with the second pole of the driving transistor T1, second poles of the second light-emitting control transistors T6, T7, T8, and T9 are respectively electrically connected with the first electrode of one sub-pixel 30, the gate electrodes of the second light-emitting control transistors T6, T7, T8, and T9 are configured to be electrically connected with the corresponding second light-emitting control signal terminals to receive light-emitting control signals. Specifically, the gate electrode of the second light-emitting control transistor T6 is electrically connected with the second light-emitting control signal terminal EM1, the gate electrode of the second light-emitting control transistor T7 is electrically connected with the second light-emitting control signal terminal EM2, the gate electrode of the second light-emitting control transistor T8 is electrically connected with the second light-emitting control signal terminal EM3, and the gate electrode of the second light-emitting control transistor T9 is electrically connected with the second light-emitting control signal terminal EM4. The second electrode of sub-pixel 30 is electrically connected with the second power supply terminal ELVSS. One of the first power terminal ELVDD and the second power terminal ELVSS is a high voltage signal terminal, and the other thereof is a low voltage signal terminal. The scanning signal terminal *Gate1* and the scanning signal terminal *Gate2* may receive the same scanning signal, or may receive different scanning signals. In some embodiments, the pixel circuit may also include another reset transistor. The another reset transistor may be electrically connected with the same signal terminal as the gate electrode of the reset transistor T5. For each of the above transistor, one of the first pole and the second pole is a source electrode, and the other thereof is a drain electrode.

The above pixel circuit may enable a plurality of sub-pixels to share the same pixel circuit, thereby reducing the space occupied by the pixel circuit. In an embodiment illustrated in FIG. 8, four sub-pixels 30 share one pixel circuit. In other embodiments, one pixel circuit may be shared by two or three sub-pixels, or, five or more sub-pixels.

In an embodiment, the driving circuit layer further includes a data signal gating circuit, one end of the data signal line is connected with the data writing transistor and the other end of the data signal line is connected with the data signal gating circuit, and the data signal gating circuit is configured to input a data signal of a selected sub-pixel to the data signal line. In this way, when it is necessary to connect data signals to selected sub-pixels, the data signal gating circuit inputs the data signals of the selected sub-pixels to the data signal line, which may prevent crosstalk of data signals between different sub-pixels, ensuring the normal display of the display substrate.

In an embodiment, the pixel opening has a plurality of sub-pixels, the plurality of sub-pixels in the same pixel opening are electrically connected with the same pixel circuit. The data signal gating circuit includes a plurality of data gating signal lines and a plurality of switch transistors respectively corresponding to at least two sub-pixels, the respective switch transistors in the same pixel opening are connected in parallel, and one end of each of switch transistors is connected with the driving chip and the other end of each of switch transistors is connected with the data signal line. The gate electrode of the switch transistor corresponding to each sub-pixel is connected with one of the data gating signal lines; and the data gating signal line is configured to turn on the switch transistor corresponding to the selected sub-pixel, such that a data signal provided by the driving chip to the selected sub-pixel is transmitted to the data signal line. This arrangement helps to reduce the number of data signal lines in the display substrate.

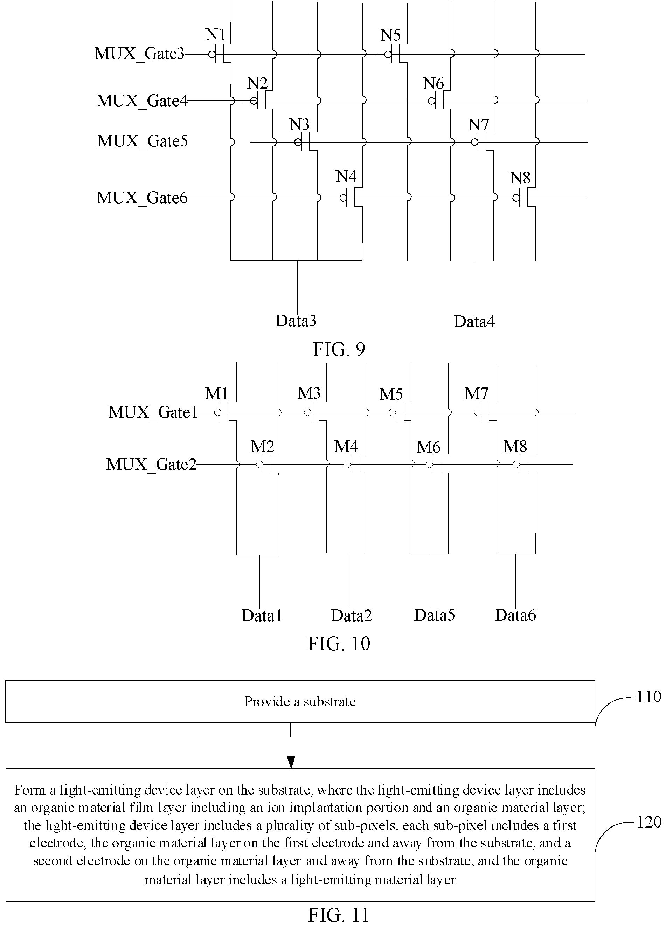

As illustrated in FIG. 9, the data signal gating circuit includes the data gating signal lines MUX_Gate3, MUX_Gate4, MUX_Gate5, and MUX_Gate6, and the switch transistors N1, N2, N3, and N4. Four sub-pixels in the same pixel opening share one pixel circuit, the four sub-pixels are in one-to-one correspondence with the switch transistors N1, N2, N3, and N4, and the switch transistors N1, N2, N3, and N4 are connected in parallel, one end of each of the four switch transistors is connected with the driving chip and the other end of each of the four switch transistors is connected with the same data signal line *Data3.* The gate electrode of each switch transistor is connected with a data gating signal line. For example, when the sub-pixel corresponding to the switch transistor N2 is selected, MUX_Gate4 provides a gating signal to the switch transistor N2 to turn on the switch transistor N2, such that the driving chip may provide data signals to the data signal line *Data3.* The data signal line *Data3* is connected with the data signal terminal *Data* of the pixel circuit, such that the driving chip may provide data signals of the selected sub-pixel to the pixel circuit through the data signal gating circuit.

The four sub-pixels corresponding to another pixel opening are arranged at an interval in the column direction, the four sub-pixels are in one-to-one correspondence with the switch transistors N5, N6, N7, and N8, and the switch transistors N5, N6, N7, and N8 are connected in parallel, one end of each of the four switch transistors is connected with the driving chip and the other end of each of the four switch transistors is connected with the same data signal line *Data4.* The switch transistor N5 and the switch transistor N1 are connected with a data gating signal line MUX Gate1, the sub-pixel corresponding to the switch transistor N6 and the switch transistor N2 are connected with a data gating signal line MUX _Gate2, the sub-pixels corresponding to the switch transistor N7 and the switch transistor N3 are connected with a data gating signal line MUX_Gate3, and the switch transistor N8 and the switch transistor N4 are connected with a data gating signal line MUX_Gate4. The sub-pixels corresponding to the switch transistors connected with the same data signal gate signal line may be in the same row or in different rows. For example, MUX_Gate4 provides a gate signal to both the switch transistor N2 and the switch transistor N6, to turn on the switch transistor N2 and the switch transistor N6 simultaneously, then the driving chip may provide data signals to the selected sub-pixel among the sub-pixel corresponding to the switch transistor N2 and the sub-pixel corresponding to the switch transistor N6.

In another embodiment, the pixel opening has a plurality of sub-pixels, the sub-pixels in the same pixel opening are electrically connected with the same pixel circuit, and the data signal gating circuit includes a plurality of data gating signal lines and a plurality of switch transistors in one-to-one correspondence with the sub-pixels. Among the sub-pixels in the same pixel opening, the switch transistors corresponding to at least two sub-pixels are connected in parallel, and one end of each of switch transistors connected in parallel is connected with the driving chip and the other end of each of switch transistors connected in parallel is connected with one of the data signal lines. Among the sub-pixels in the same pixel opening, the switch transistors corresponding to the sub-pixels are connected with at least two data signal lines. At least two switch transistors connected with different data signal lines are connected with the same data gating signal line. The data gating signal line is configured to turn on the respective switch transistors corresponding to selected sub-pixels in the same row, such that the data signal provided by the driving chip to the selected sub-pixel is transmitted to the data signal line. This arrangement helps to reduce the number of data gating signal lines in the display substrate.

As illustrated in FIG. 10, the data signal gating circuit includes the data signal gating signal lines MUX_Gate1 and MUX_Gate2, and the switch transistors M1, M2, M5, and M6. The four sub-pixels in the same pixel opening share one pixel circuit. The four sub-pixels are in one-to-one correspondence with the switch transistors M1, M2, M3, and M4. The switch transistors M1 and M2 are connected in parallel, one end of each of the two switch transistors M1 and M2 is connected with the driving chip and the other end of each of the two switch transistors M1 and M2 is connected with the data signal line *Data1.* The switch transistors M3 and M4 are connected in parallel, one end of each of the two switch transistors M3 and M4 is connected with the driving chip and the other end of each of the two switch transistors M3 and M4 is connected with the data signal line *Data2.* The switch transistors M1 and M3 are connected with the same data signal gating signal line MUX _Gate 1, and the switch transistors M2 and M4 are connected with the same data signal gating signal line MUX_Gate2. The sub-pixels corresponding to the switch transistors connected with the same data signal gating signal line may be in the same row or in different rows. When MUX_Gate1 provides a gating signal to the switch transistors M1 and M3 to both turn on the switch transistors M1 and M3, such that the driving chip may provide the data signal of the selected sub-pixel to the data signal line *Data1* or the data signal line *Data2.* The data signal line *Data1* and the data signal line *Data2* are connected with the data signal terminal *Data* of the pixel circuit, such that the driving chip may provide data signals of the selected sub-pixel to the pixel circuit through the data signal gating circuit.

The four sub-pixels corresponding to another pixel opening are in one-to-one correspondence with the switch transistors M5, M6, M7, and M8, and the switch transistors M5 and M6 are connected in parallel, one end of each of the two switch transistors M5 and M6 is connected with the driving chip and the other end of each of the two switch transistors M5 and M6 is connected with the same data signal line *Data5.* The switch transistors M7 and M8 are connected in parallel, one end of each of the two switch transistors M7 and M8 is connected with the driving chip and the other end of each of the two switch transistors M7 and M8 is connected with the data signal line *Data6.* The switch transistors M5 and M7 and the switch transistors M1 and M3 are connected with the same data signal gating signal line MUX_Gate1, and the switch transistors M6 and M8 and the switch transistors M2 and M4 are connected with the same data signal gating signal line MUX _Gate2. For example, MUX_Gate1 provides a gate signal to the switch transistors M1, M3, M5, and M7 simultaneously, to turn on the switch transistors M1, M3, M5, and M7 simultaneously, then the driving chip may provide data signals to the selected sub-pixel among the sub-pixels corresponding to the switch transistors M1, M3, M5, and M7.

In an embodiment, as illustrated in FIG. 3, an ion implantation portion 23 is provided on the pixel defining layer 40 and away from the substrate 10, and the ion implantation portion 23 is to electrically isolate the sub-pixels 30 corresponding to the adjacent pixel openings 41. In this way, the ion implantation portion 23 may further avoid electrical crosstalk between the sub-pixels corresponding to the adjacent pixel openings 41. In an embodiment illustrated in FIG. 3, there is one sub-pixel in one pixel opening.

In some embodiments, when a pixel opening 41 has at least two sub-pixels 30, an ion implantation portion may be provided between adjacent sub-pixels 30 in the same pixel opening, and the ion implantation portion may be provided on the pixel defining layer 40 and away from the substrate.

Embodiments of the present disclosure further provide a method of manufacturing a display substrate. As illustrated in FIG. 11, the manufacture method includes the following steps 110 and 120. A detailed introduction will be given below.

At step 110, a substrate is provided.

At step 120, a light-emitting device layer is formed on the substrate, the light-emitting device layer includes an organic material film layer, the organic material film layer includes an ion implantation portion and an organic material layer; the light-emitting device layer includes a plurality of sub-pixels, each sub-pixel includes a first electrode, the organic material layer on the first electrode and away from the substrate, and a second electrode on the organic material layer and away from the substrate, and the organic material layer includes a light-emitting material layer.

The step of forming the ion implantation portion includes: forming an organic film layer on the first electrode, performing ion implantation on the organic film layer to form an ion implantation portion, a portion of the organic film layer outside the ion implantation portion forms at least part film layer of the organic material layer, and the ion implantation portion is to electrically isolate film layers of the adjacent two sub-pixels that are between the first electrodes and a surface of the light-emitting material layer away from the substrate.

The organic film layer may have at least one film layer less than the organic material film layer, for example, the organic film layer does not include an electron injection layer, while the organic material film layer includes an organic film layer and an electron injection layer on the organic film layer and away from the substrate.

In an embodiment, the display substrate further includes a pixel defining layer on the substrate, and the pixel defining layer is provided with a plurality of pixel openings. At least one sub-pixel is in one pixel opening.

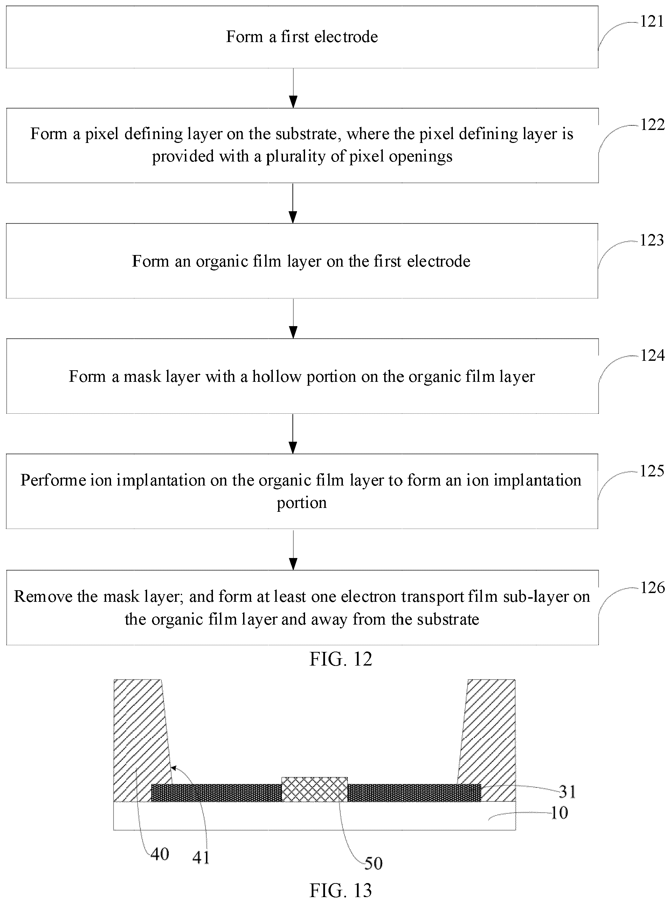

In an embodiment, the step of performing ion implantation on the organic film layer to form the ion implantation portion is performed before a step of forming the second electrode. In this embodiment, as illustrated in FIG. 12, the step 120 of forming a light-emitting device layer on the substrate may include the following steps 121 to 126. A detailed introduction will be given below. The accompanying drawing regarding these steps mainly illustrate the implementation of one pixel opening corresponding to a plurality of sub-pixels.

At step 121, the first electrode is formed.

In an embodiment, the step of forming the first electrode may be implemented by the process described below.

Firstly, the first conductive film layer, the second conductive film layer on the first conductive film layer and away from the substrate, and the third conductive film layer on the second conductive film layer and away from the substrate are sequentially formed. The material of the second conductive film layer is selected from at least one of aluminum or molybdenum, and the materials of the first conductive film layer and the third conductive film layer are respectively selected from at least one of titanium, titanium nitride, or transparent metal oxide, and the orthographic projections of the first electrode film layer, the second conductive film layer, and the third conductive film layer onto the substrate cover the pixel defining layer and the pixel openings.

The orthographic projections of the first conductive film layer, the second conductive film layer, and the third conductive film layer onto the substrate may cover the substrate. The first conductive film layer, the second conductive film layer, and the third conductive film layer may be formed by a sputtering process.

Subsequently, etching is performed by a dry etching process or a wet etching process on the first conductive film layer, the second conductive film layer, and the third conductive film layer, to obtain the first electrode.

In another embodiment, the step of forming the first electrode may be implemented by the process described below.

Firstly, the first conductive film layer, the second conductive film layer on the first conductive film layer and away from the substrate, and the third conductive film layer on the second conductive film layer and away from the substrate are sequentially formed. The material of the second conductive film layer includes silver, and the materials of the first conductive film layer and the third conductive film layer are respectively selected from at least one of titanium, titanium nitride, or transparent metal oxide, and the orthographic projections of the first electrode film layer, the second conductive film layer, and the third conductive film layer onto the substrate cover the pixel defining layer and the pixel openings.

The orthographic projections of the first conductive film layer, the second conductive film layer, and the third conductive film layer onto the substrate may cover the substrate. The first conductive film layer, the second conductive film layer, and the third conductive film layer may be formed by a sputtering process.

Subsequently, etching is performed by a wet etching process on the first conductive film layer, the second conductive film layer, and the third conductive film layer, to obtain the first electrode.

In an embodiment, when at least two sub-pixels with the same luminescence color are provided in the same pixel opening, after step 121, the manufacture method further includes the process described below.

An isolation column is formed by a dry etching process, the isolation column is between adjacent two first electrodes in the same pixel opening, and a height of the isolation column is greater than a thickness of the first electrode; and a material of the isolation column includes an inorganic material.

At step 122, a pixel defining layer is formed on the substrate, where the pixel defining layer is provided with a plurality of pixel openings.

The pixel defining layer covers the edge area of the first electrode, and each pixel opening exposes part of the first electrode.

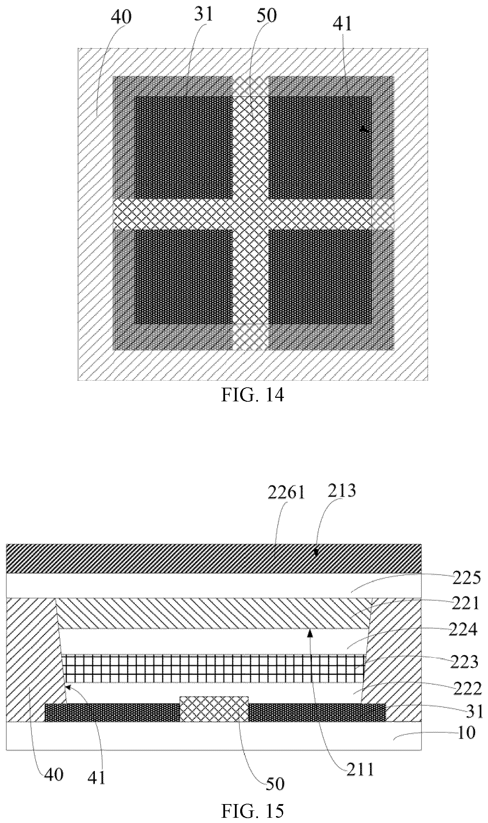

Through this step, the first intermediate structure as illustrated in FIG. 13 and FIG. 14 may be obtained. As illustrated in FIG. 13 and FIG. 14, among the first electrodes 31 in the same pixel opening 41, an isolation column 50 is formed between two first electrodes 31 that are adjacent to each other, the isolation column 50 may fill the gap between any two first electrodes 31 that are adjacent to each other.

At step 123, an organic film layer is formed on the first electrode.

In an embodiment, the organic film layer includes a first organic layer between the first electrode and the light-emitting material layer and a third organic layer on the light-emitting material layer and away from the substrate, the first organic layer includes at least one of a hole injection layer, a hole transport layer, or an electron blocking layer, and the third organic layer includes at least one of an electron injection layer, an electron transport layer, or a hole blocking layer.

Through step 123, the second intermediate structure as illustrated in FIG. 15 may be obtained. In an embodiment illustrated in FIG. 15, there are a plurality of sub-pixels with the same luminescence color in one pixel opening. As illustrated in FIG. 15, the first organic layer 211 is between the first electrode 31 and the light-emitting material layer 221, and the third organic layer 213 is on the light-emitting material layer 221 and away from the substrate 10.

In an embodiment illustrated in FIG. 15, the first organic layer 211 includes a hole injection layer 222, a hole transport layer 223, and an electron blocking layer 224, the third organic layer 213 includes a hole blocking layer 225 and a first electron transport film sub-layer 2261.

At step 124, a mask layer with a hollow portion is formed on the organic film layer.

In an embodiment, the step of forming a mask layer with the hollow portion on the organic film layer includes the process described below.

Firstly, a protective layer and a barrier layer are sequentially formed on the organic film layer, where the material of the protective layer includes a fluorinated polymer material.

Subsequently, exposure processing is simultaneously performed on the protective layer and the barrier layer.

Subsequently, development processing is sequentially performed on the barrier layer and the protective layer, to obtain a patterned protective layer and a patterned barrier layer, where the orthographic projection of the patterned barrier layer onto the substrate is within the orthographic projection of the patterned protective layer onto the substrate, to obtain a mask layer including the patterned protective layer and the patterned barrier layer.

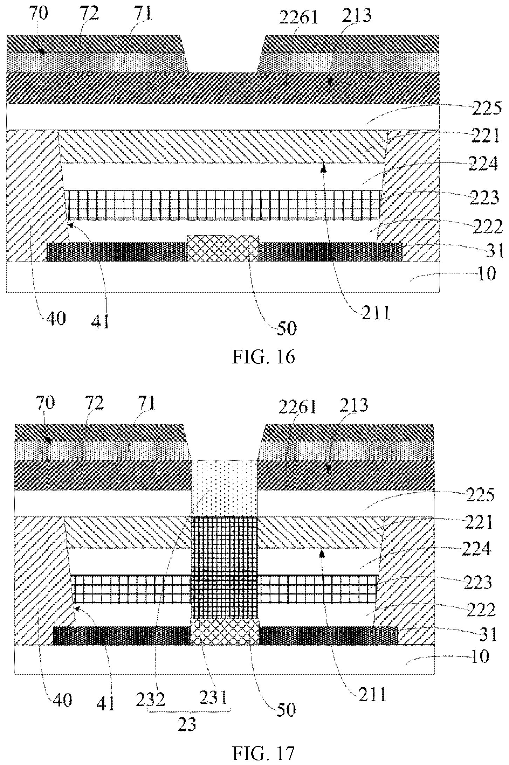

Through this step, the third intermediate structure as illustrated in FIG. 16 may be obtained. As illustrated in FIG. 16, the mask layer 70 includes a patterned protective layer 71 and a patterned barrier layer 72 on the patterned protective layer 71 and away from the substrate 10.

By arranging a mask layer including a patterned barrier layer and a patterned protective layer, the protective layer has good compactness, which may prevent some substances in the barrier layer from entering the organic film layer to affect the light-emitting performance of the sub-pixels.

At step 125, ion implantation is performed on the organic film layer to form an ion implantation portion.

In this step, performing ion implantation on the organic film layer to form an ion implantation portion includes: performing ion implantation on the organic film layer through the hollow portion of the mask layer. The mask layer may limit the area for ion implantation to prevent ions from being injected into a light-emitting area of the sub-pixel to affect light-emitting performance of the sub-pixels.

In this step, P-type ions and/or N-type ions may be injected into the organic film layer by an ion implantation process, to form an ion implantation portion.

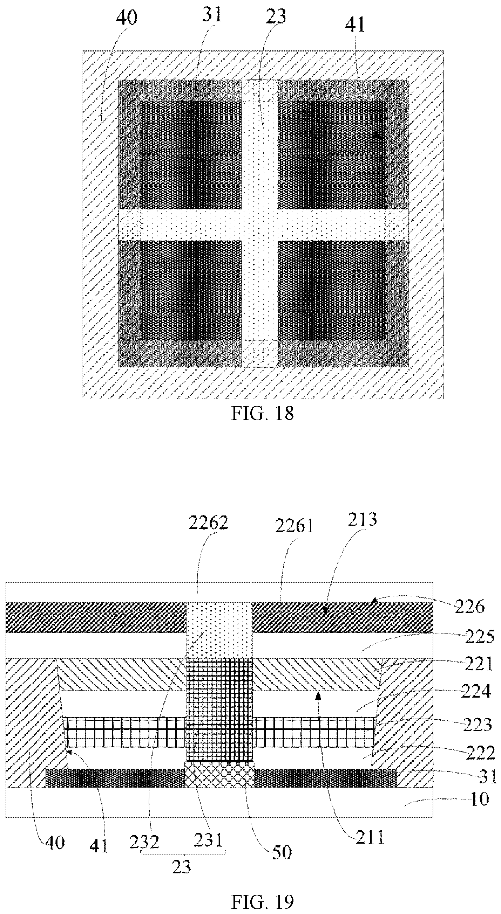

In an embodiment, the first electrode is an anode, and the second electrode is a cathode. In this step, N-type ions may be injected into the first organic layer and the light-emitting material layer by an ion implantation process, to obtain an N-type doped layer penetrating through the first organic layer and the light-emitting material layer, and then P-type ions may be injected into the third organic layer to obtain a P-type doped layer penetrating through the third organic layer. Through this step, the fourth intermediate structure as illustrated in FIG. 17 and FIG. 18 may be obtained, and it should be noted that FIG. 18 only illustrates part of the film layers. As illustrated in FIG. 17, the ion implantation portion 23 includes an N-type doped layer 231 and a P-type doped layer 232 on the N-type doped layer 231 and away from the substrate 10. In an embodiment illustrated in FIG. 17, there are a plurality of sub-pixels in a pixel opening, and the ion implantation portion 23 is formed in the pixel opening 41. In an embodiment illustrated in FIG. 17, the orthographic projection of the ion implantation portion 23 onto the substrate 10 is in the pixel opening 41. In other embodiments, the orthographic projection of the ion implantation portion 23 onto the substrate 10 may be on the pixel defining layer 40, that is, the ion implantation portion 23 is between adjacent two pixel openings 41.

In an embodiment, when injecting N-type ions, the range of injection energy may be 30keV~80keV, and the range of injection concentration may be 1E14atom/cm²~5E15atom/cm²; and when injecting P-type ions, the range of injection energy may be 10keV~50keV, and the range of injection concentration may be 1E14atom/cm²~5E15atom/cm².

At step 126, the mask layer is removed; and at least one electron transport film sub-layer is formed on the organic film layer and away from the substrate.

Through this step, the fifth intermediate structure as illustrated in FIG. 19 may be obtained. As illustrated in FIG. 19, the second electron transport film sub-layer 2262 is formed on the organic film layer and away from the substrate, to obtain an electron transport layer 226 including the first electron transport film sub-layer 2261 and the second electron transport film sub-layer 2262.

In an embodiment, the mask layer may be removed by a stripping process under a nitrogen environment, and then the obtained fifth intermediate structure is transferred to a vacuum low-temperature baking oven, to remove residual organic solvent, where the baking time may be 30min~60min, and the baking temperature may be 60°C~80°C.

In an embodiment, after step 126, step 120 of forming a light-emitting device layer on the substrate further includes: forming an electron injection layer on the electron transport layer 226 and away from the substrate, a second electrode on the electron injection layer and away from the substrate, and a light extraction layer on the second electrode and away from the substrate.

In an embodiment, after step 120, the manufacture method further includes: forming an encapsulation layer on the light-emitting device layer and away from the substrate.

Through this step, the display substrate as illustrated in FIG. 1 may be obtained. As illustrated in FIG. 1, the encapsulation layer 60 covers the light-emitting device layer 20.

In another embodiment, there is one sub-pixel in one pixel opening, and when the ion implantation portion 23 formed in step 125 is on the pixel defining layer, the display substrate as illustrated in FIG. 3 may be finally prepared.

In another embodiment, the step of performing ion implantation on the organic film layer to form an ion implantation portion is performed after the step of forming the second electrode. This is different from the above-mentioned embodiment in which the step of performing ion implantation on the organic film layer to form the ion implantation portion is performed before the step of forming the second electrode as described below.

After step 123, step 120 of forming a light-emitting device layer on the substrate further includes: firstly, sequentially forming an electron injection layer on the electron transport layer and away from the substrate, a second electrode on the electron injection layer and away from the substrate, a light extraction layer on the second electrode and away from the substrate, and an encapsulation layer on the light extraction layer and away from the substrate; subsequently, forming a patterned shielding layer on the encapsulation layer and away from the substrate; and subsequently, performing ion implantation through a hollow of the shielding layer to form an ion implantation portion.

When the display substrate includes an isolation column, the ion implantation portion penetrates the film layers between the isolation column and the surface of the second electrode away from the substrate; and when the display substrate does not include an isolation column, the ion implantation portion penetrates the film layers between the first electrode and the surface of the second electrode away from the substrate.

Subsequently, the shielding layer is removed.

Through this embodiment, the display substrate as illustrated in FIG. 2 may be obtained. As illustrated in FIG. 2, the ion implantation portion 23 includes an N-type doped layer 231 and a P-type doped layer 232. The N-type doped layer 231 penetrates the first organic layer 211 and the light-emitting material layer 221, and the P-type doped layer 232 penetrates the film layers between the light-emitting material layer 221 and the surface of the encapsulation layer 60 away from the substrate.

In this embodiment, in order to reduce the energy and concentration of ion implantation, the encapsulation layer 60 may include only one inorganic layer.

In this embodiment, due to the more film layers penetrated by the ion implantation portion, the ion implantation energy is greater. In some embodiments, the energy range of ion implantation may be 60-120kev, and the concentration range of ion implantation may be 5E14atom/cm²~8E16atom/cm².

Embodiments of the manufacture method of a display substrate and embodiments of a display substrate provided in the embodiments of the present disclosure belong to the same inventive concept, the relevant details and descriptions of beneficial effects can be referred to each other and will not be described herein again.

Embodiments of the present disclosure further provide a display device, which includes the display substrate described in any one of the above embodiments.

In an embodiment, the display device further includes a cover plate on the display substrate and away from the base.

In an embodiment, the display device further includes a housing, and the display panel is embedded in the housing.

The display device in the embodiments of the present disclosure may be any product or component having a display function, such as an electronic paper, a mobile phone, a tablet computer, a television, a notebook computer, a digital photo frame, and a vehicle-mounted display device, etc.

It is to be noted that in the accompanying drawings, the dimensions of layers and regions may be exaggerated for clarity of illustration. It will be understood that when an element or a layer is referred to as being "above" or "on" another element or layer, it may be directly on the other element, or intervening layers may be present. In addition, it will be understood that when an element or a layer is referred to as being "under" or "below" another element or layer, it may be directly under the other element, or one or more intervening layers or elements may be present. In addition, it will also be understood that when a layer or an element is referred to as being "between" two layers or two elements, it may be the only layer between the two layers or two elements, or one or more intervening layers or elements may be present. Like reference numerals indicate like elements throughout.

Those skilled in the art will readily conceive other embodiments of the present disclosure upon consideration of the specification and practice of the various embodiments disclosed herein. The present disclosure is intended to cover any variation, use, or adaptive change of this disclosure. These variations, uses, or adaptive changes follow the general principles of this disclosure and include common general knowledge or common technical means in the art that are not disclosed in this disclosure. The specification and the embodiments are considered as merely exemplary, and the real scope and spirit of the present disclosure are pointed out in the following claims.

It should be understood that this disclosure is not limited to the precise structures described above and illustrated in the accompanying drawings, and various modifications and changes may be made without departing from the scope of the present disclosure. The scope of the present disclosure is limited only by the appended claims.

## Claims

1. A display substrate, comprising:
a substrate; and
a light-emitting device layer on the substrate, wherein the light-emitting device layer comprises an organic material film layer, the organic material film layer comprises an organic material layer and an ion implantation portion, and a material of the ion implantation portion comprises a material of the organic material layer and doped ions;
wherein the light-emitting device layer comprises a plurality of sub-pixels, each sub-pixel comprises a first electrode, the organic material layer on the first electrode and away from the substrate, and a second electrode on the organic material layer and away from the substrate; wherein the organic material layer comprises a light-emitting material layer; wherein first electrodes of adjacent sub-pixels among the plurality of sub-pixels are arranged at an interval; and wherein the ion implantation portion is between adjacent two sub-pixels among the plurality of sub-pixels, and the ion implantation portion is to electrically isolate film layers of the adjacent two sub-pixels that are between the first electrodes and a surface of the light-emitting material layer away from the substrate.

2. The display substrate according to claim 1, wherein the ion implantation portion comprises a P-type doped layer and an N-type doped layer.

3. The display substrate according to claim 1, wherein one of the first electrode and the second electrode is an anode and the other one of the first electrode and the second electrode is a cathode, and the ion implantation portion comprises an N-type doped layer and a P-type doped layer on the N-type doped layer and away from the anode.

4. The display substrate according to claim 3, wherein the first electrode is an anode, the second electrode is a cathode, and the organic material layer comprises a first organic layer between the first electrode and the light-emitting material layer and a second organic layer between the light-emitting material layer and the second electrode; wherein the first organic layer comprises a hole injection layer, a hole transport layer, an electron blocking layer, or any combination thereof, and the second organic layer comprises an electron injection layer, an electron transport layer, a hole blocking layer, or any combination thereof; and
wherein the N-type doped layer penetrates through the first organic layer and the light-emitting material layer; and a distance between the substrate and a surface of the P-type doped layer away from the substrate is less than or equal to a distance between the substrate and a surface of the second organic layer away from the substrate, or,
the display substrate further comprises an encapsulation layer on the second electrode and away from the substrate, and the P-type doped layer penetrates film layers between the light-emitting material layer and a surface of the encapsulation layer away from the substrate.

5. The display substrate according to claim 1, further comprising a pixel defining layer on the substrate, and the pixel defining layer is provided with a plurality of pixel openings; wherein at least two sub-pixels with a same luminescence color are provided in a same pixel opening, and at least part of the organic material layers of the at least two sub-pixels is in the pixel opening; wherein among the at least two sub-pixels in the same pixel opening, the ion implantation portion is between adjacent two sub-pixels; and the ion implantation portion is to electrically isolate film layers of the adjacent two sub-pixels in the same pixel opening that are between the first electrodes and a surface of the light-emitting material layer away from the substrate.

6. The display substrate according to claim 5, wherein the display substrate further comprises an isolation column in the pixel opening, the isolation column is closer to the substrate than the ion implantation portion and between adjacent two first electrodes, and a height of the isolation column is greater than a thickness of the first electrode.

7. The display substrate according to claim 6, wherein a material of the isolation column comprises an inorganic material.

8. The display substrate according to claim 5, wherein the display substrate further comprises a driving circuit layer between the light-emitting device layer and the substrate, wherein the driving circuit layer comprises a plurality of pixel circuits, and at least two of the at least two sub-pixels in the same pixel opening, are electrically connected with a same pixel circuit.

9. The display substrate according to claim 8, wherein the driving circuit layer further comprises a data signal gating circuit and a data signal line, wherein the pixel circuit comprises a data writing transistor, one end of the data signal line is connected with the data writing transistor, the other end of the data signal line is connected with the data signal gating circuit, and the data signal gating circuit is configured to input a data signal of a selected sub-pixel to the data signal line.

10. The display substrate according to claim 9, wherein there are a plurality of the sub-pixels in the pixel opening, and the plurality of the sub-pixels in the pixel opening are electrically connected with a same pixel circuit; the data signal gating circuit comprises a plurality of data gating signal lines and a plurality of switch transistors respectively corresponding to the sub-pixels; the switch transistors corresponding to a same pixel opening are connected in parallel, one end of each of the switch transistors is connected with a driving chip, and the other end of each of the switch transistors is connected with a same data signal line; wherein a gate electrode of the switch transistor corresponding to each sub-pixel is connected with one of the data gating signal lines; and the data gating signal line is configured to turn on the switch transistor corresponding to a selected sub-pixel, such that a data signal provided by the driving chip to the selected sub-pixel is transmitted to the data signal line.

11. The display substrate according to claim 9, wherein there are a plurality of the sub-pixels in the pixel opening, and the plurality of the sub-pixels in the pixel opening are electrically connected with a same pixel circuit; the data signal gating circuit comprises a plurality of data gating signal lines and a plurality of switch transistors respectively corresponding to the sub-pixels; among the at least two sub-pixels in the same pixel opening, switch transistors corresponding to at least two of the at least two sub-pixels are connected in parallel, one end of each of the switch transistors connected in parallel is connected with a driving chip, and the other end of each of the switch transistors connected in parallel is connected with one of the data signal lines; among the at least two sub-pixels in the same pixel opening, the switch transistors corresponding to the sub-pixels are connected with at least two data signal lines; at least two switch transistors connected with different data signal lines are connected with a same data gating signal line; and the data gating signal line is configured to turn on switch transistors corresponding to selected sub-pixels connected with the same data gating signal line, such that a data signal provided by the driving chip to the selected sub-pixels is transmitted to the data signal line.

12. The display substrate according to claim 1, wherein the first electrode comprises a first conductive layer, a second conductive layer on the first conductive layer and away from the substrate, and a third conductive layer on the second conductive layer and away from the substrate, a material of the second conductive layer is selected from silver, aluminum, molybdenum, or any combination thereof, a material of the first conductive layer is selected from titanium, titanium nitride, transparent metal oxide, or any combination thereof, and a material of the third conductive layer is selected from titanium, titanium nitride, transparent metal oxide, or any combination thereof.

13. The display substrate according to claim 12, wherein the display substrate further comprises a pixel defining layer on the substrate, and the pixel defining layer is provided with a plurality of pixel openings; at least two sub-pixels with a same luminescence color are provided in a same pixel opening, and at least part of the organic material layers of the at least two sub-pixel is in the pixel opening; and among the at least two sub-pixels in the same pixel opening, a distance between the first electrodes of adjacent two sub-pixels is less than 5.0µm.

14. The display substrate according to claim 1, wherein the display substrate further comprises a pixel defining layer on the substrate, and the pixel defining layer is provided with a plurality of pixel openings; at least one sub-pixel is provided in a same pixel opening, and at least part of the organic material layer of the at least one sub-pixel is in the pixel opening; and the ion implantation portion is on the pixel defining layer and away from the substrate, and the ion implantation portion is to electrically isolate the sub-pixels in adjacent pixel openings.

15. The display substrate according to claim 1, wherein the first electrode is an anode, and the second electrode is a cathode; and the organic material layer comprises an electron transport layer between the light-emitting material layer and the second electrode, the electron transport layer comprises at least two electron transport film sub-layers, and at least one of the electron transport film sub-layers is on the ion implantation portion and away from the substrate.

16. The display substrate according to claim 15, wherein the electron transport layer comprises a first electron transport film sub-layer and a second electron transport film sub-layer on the first electron transport film sub-layer and away from the substrate; the ion implantation portion penetrates through the first electron transport film sub-layer; and the second electron transport film sub-layer is on the ion implantation portion and away from the substrate, and is in direct contact with the ion implantation portion.

17. The display substrate according to claim 1, wherein the sub-pixels comprise a first color sub-pixel, a second color sub-pixel, and a third color sub-pixel, and there are a plurality of pixel openings arranged in a plurality of columns;
wherein among adjacent two columns of the pixel openings, first color sub-pixels and second color sub-pixels are in one column of the pixel openings, the pixel openings of the first color sub-pixels and the pixel openings of the second color sub-pixels are alternately arranged, and third color sub-pixels are in the other column of the pixel openings; and,
wherein there are at least two first color sub-pixels in a pixel opening of the first color sub-pixels, there are at least two second color sub-pixels in a pixel opening of the second color sub-pixels, there are at least two third color sub-pixels in a pixel opening of the third color sub-pixels, and respective sub-pixels in a same pixel opening are arranged at an interval in a row direction, or respective sub-pixels in a same pixel opening are arranged at an interval in a column direction; or,
there are a plurality of the first color sub-pixels in the pixel opening of the first color sub-pixels, there are a plurality of the second color sub-pixels in the pixel opening of the second color sub-pixels, there are a plurality of the third color sub-pixels in the pixel opening of the third color sub-pixels, and a plurality of the sub-pixels in a same pixel opening are arranged in a plurality of rows and columns.

18. A method of manufacturing a display substrate, comprising:
providing a substrate; and
forming a light-emitting device layer on the substrate;
wherein the light-emitting device layer comprises an organic material film layer, the organic material film layer comprises an ion implantation portion and an organic material layer; the light-emitting device layer comprises a plurality of sub-pixels, each sub-pixel comprises a first electrode, the organic material layer on the first electrode and away from the substrate, and a second electrode on the organic material layer and away from the substrate, and the organic material layer comprises a light-emitting material layer; and
forming the ion implantation portion comprises:
forming an organic film layer on the first electrode, performing ion implantation on the organic film layer to form the ion implantation portion, a portion of the organic film layer outside the ion implantation portion forms at least part film layer of the organic material layer, and wherein the ion implantation portion is to electrically isolate film layers of the adjacent two sub-pixels that are between the first electrodes and a surface of the light-emitting material layer away from the substrate.

19. The method according to claim 18, wherein performing ion implantation on the organic film layer to form the ion implantation portion comprises:
injecting P-type ions and/or N-type ions into the organic film layer by an ion implantation process, to form the ion implantation portion.

20. The method according to claim 19, wherein the organic film layer comprises a first organic layer between the first electrode and the light-emitting material layer, and a third organic layer on the light-emitting material layer and away from the substrate; the first organic layer comprises at least one of a hole injection layer, a hole transport layer, or an electron blocking layer; and the third organic layer comprises at least one of an electron injection layer, an electron transport layer, or a hole blocking layer; and
injecting N-type ions into the first organic layer and the light-emitting material layer by an ion implantation process, to obtain an N-type doped layer penetrating through the first organic layer and the light-emitting material layer, and injecting P-type ions into the third organic layer to obtain a P-type doped layer penetrating through the third organic layer.

21. The method according to claim 18, wherein the display substrate further comprises a pixel defining layer on the substrate, and the pixel defining layer is provided with a plurality of pixel openings;
at least two sub-pixels with a same luminescence color are provided in a same pixel opening, at least part of the organic material layers of the at least two sub-pixels is in the pixel opening, and the ion implantation portion is formed between adjacent two sub-pixels in the same pixel opening; or,
the ion implantation portion is formed on the pixel defining layer and away from the substrate.

22. The method according to claim 21, wherein when at least two sub-pixels with the same luminescence color are provided in the same pixel opening, before forming the ion implantation portion, the method further comprises:
forming an isolation column by a dry etching process, the isolation column is between the adjacent two first electrodes in the same pixel opening, and a height of the isolation column is greater than a thickness of the first electrode; and a material of the isolation column comprises an inorganic material.

23. The method according to claim 18, wherein performing ion implantation on the organic film layer to form the ion implantation portion is performed before forming the second electrode;
before performing ion implantation on the organic film layer to form the ion implantation portion, the method further comprises: forming a mask layer with a hollow portion on the organic film layer;
wherein forming the mask layer with the hollow portion on the organic film layer comprises:
sequentially forming a protective layer and a barrier layer on the organic film layer, wherein a material of the protective layer comprises a fluorinated polymer material;
simultaneously performing exposure processing on the protective layer and the barrier layer;
sequentially performing development processing on the barrier layer and the protective layer, to obtain a patterned protective layer and a patterned barrier layer, wherein an orthographic projection of the patterned barrier layer onto the substrate is within an orthographic projection of the patterned protective layer onto the substrate, to obtain the mask layer comprising the patterned protective layer and the patterned barrier layer;
performing ion implantation on the organic film layer to form the ion implantation portion comprises: performing ion implantation on the organic film layer through the hollow portion of the mask layer; and
wherein the organic material layer comprises an electron transport layer comprising at least two electron transport film sub-layers; after performing ion implantation on the organic film layer to form the ion implantation portion, the method further comprises: removing the mask layer; and forming at least one electron transport film sub-layer on the organic film layer and away from the substrate;
or,
the display substrate further comprises an encapsulation layer on the light-emitting device layer and away from the substrate, the encapsulation layer only comprises an inorganic layer, and a step of performing ion implantation on the organic film layer to form the ion implantation portion is performed after a step of forming the second electrode.

24. The method according to claim 18, wherein forming the first electrode comprises:
sequentially forming a first conductive film layer, a second conductive film layer on the first conductive film layer and away from the substrate, and a third conductive film layer on the second conductive film layer and away from the substrate, wherein a material of the second conductive film layer is selected from at least one of aluminum or molybdenum, and materials of the first conductive film layer and the third conductive film layer are respectively selected from at least one of titanium, titanium nitride, or transparent metal oxide, and orthographic projections of the first electrode film layer, the second conductive film layer, and the third conductive film layer onto the substrate cover a pixel defining layer and pixel openings;
etching the first conductive film layer, the second conductive film layer, and the third conductive film layer by a dry etching process or a wet etching process, to obtain the first electrode;
or,
sequentially forming the first conductive film layer, the second conductive film layer on the first conductive film layer and away from the substrate, and the third conductive film layer on the second conductive film layer and away from the substrate, wherein a material of the second conductive film layer comprises silver, and materials of the first conductive film layer and the third conductive film layer are respectively selected from at least one of titanium, titanium nitride, or transparent metal oxide, and orthographic projections of the first electrode film layer, the second conductive film layer, and the third conductive film layer onto the substrate cover the pixel defining layer and the pixel openings;
etching the first conductive film layer, the second conductive film layer, and the third conductive film layer by the wet etching process, to obtain the first electrode.

25. A display device, comprising the display substrate according to any one of claims 1 to 17.
